# EUROPEAN PATENT SPECIFICATION

(11) **EP 4 009 388 B1**
(45) Date of publication and mention of the grant of the patent: **02.07.2025**
(21) Application number: 20211531.7
(22) Date of filing: 03.12.2020
(51) Int. Cl.: H10N 50/01, H10N 50/85, H10N 70/20, H01F 10/193

(54) **METHOD FOR MAKING MESOSURFACES FOR MAGNETIC RACETRACKS**
VERFAHREN ZUM ERZEUGEN VON MESO-OBERFLÄCHEN FÜR MAGNETISCHE RACETRACKS
MÉTHODE POUR RÉALISER DE MÉSOSURFACES POUR LES PISTES DE COURSE MAGNÉTIQUES

(43) Date of publication of application: 08.06.2022
(73) Proprietor: Max-Planck-Gesellschaft zur Förderung der Wissenschaften e.V., 80539 München (DE)
(72) Inventor: PARKIN, Stuart S.P., 06118 Halle (DE)
(74) Representative: Schweitzer, Klaus

(56) References cited:
- CN-A- 109 873 075
- US-A1- 2008 137 406
- US-A1- 2008 243 972
- CUI B ET AL: "Direct imaging of structural changes induced by ionic liquid gating leading to engineered three-dimensional meso-structures", NATURE COMMUNICATIONS, vol. 9, 3055, 3 August 2018 (2018-08-03), XP055802614, DOI: 10.1038/s41467-018-05330-1
- CUI B ET AL: "Supplementary Information", 3 August 2018 (2018-08-03), XP055802615, Retrieved from the Internet <URL:http://www.nature.com/articles/s41467-018-05330-1> [retrieved on 20210507], DOI: 10.1038/s41467-018-05330-1
- LU N ET AL: "Electric-field control of tri-state phase transformation with a selective dual-ion switch", NATURE, vol. 546, no. 7656, 31 May 2017 (2017-05-31), pages 124 - 128, XP002794615, DOI: 10.1038/NATURE22389

## Description

Mesosurfaces can be described as surfaces which exhibit at least two surface areas which are delineated from each other by a sharp boundary and wherein the first of the at least two areas exhibits a certain defined physical property which is distinguished from the one of the at least second area. Thus, a mesosurface exhibits a surface texture of delineated, distinguished physical properties on the meso-scale, which means that the delineated surface areas are in the "meso" range of between 10 nm² to 1000 µm². A typical "physical property" for mesosurfaces is its magnetic property i.e. the emergent magnetism from a collection of oriented electron spins.

The development of magnetic textures on the meso-scale has applications ranging from spin ice to magnetic logic and neuromorphic computing (see: e.g. https://en.wikipedia.org/wiki/Spin-ice, https://en.wikipedia.org/wiki/Magneticlogic, https://en.wikipedia.org/wiki/Neuromor-phic engineering, or references 1-7). Magnetic conduits for the controlled propagation of spin waves or magnetic racetracks that underlie a novel, high performance non-volatile magnetic memory, are other examples of magnetic meso-structures (see e.g. references 8-11, 18, 19). Magnetic racetrack structures on/with substantially planar surfaces have previously been fabricated by lithographic patterning or micro-molding of magnetic layers (see e.g. references 18, 19). Recently, some novel phenomena such as ultra-broadband coherent perfect absorption were demonstrated, where a 0.3 nm thick film could absorb all electromagnetic waves across the RF, microwave, and terahertz frequencies. This is another application, which may be accessed by mesosurfaces.

### OBJECT OF THE INVENTION

For the fabrication of optical mesosurfaces, two main approaches were used so far (see references 12, 13):
i) top-down methods which rely on photolithography or electron-beam lithography and following etching, deposition, and lift-off processes;
ii) bottom-up approaches that include laser/ion-beam printing, or self-assembly methods.

Thus, most reported mesosurfaces need an additive or subtractive fabrication process and have static functionalities that depend on their fixed geometrical parameters and cannot be changed after fabrication. As a consequence, these techniques lead to irreversible modifications of the mesosurface material thereby excluding dynamic adaptations/modifications of the mesosurface. Moreover, most of these methods are limited to be applied to planar surfaces only, thereby excluding its application to 3D objects.

It was, therefore, an object of the present invention to avoid the above-mentioned disadvantages and to provide for an easier (less process steps) and more flexible method of manufacture of mesosurfaces for magnetic racetracks, allowing for smaller and more complex structures and for a dynamic modification of the mesosurface, which *inter alia* means that the surface modifications are reversible.

### BRIEF DESCRIPTION OF THE INVENTION

This object is achieved with the use of a mesosurface in a magnetic racetrack according to claim 1, wherein the mesosurface is manufactured by a method comprising the steps of:
I. providing a substrate which exhibits at least two distinct measurable states of an electron spin property and which can stably but reversibly be transitioned from
   a. a first state of the electron spin property into at least
   b. one second state of the electron spin property which is measurably distinct from the first state,
II. creating on a surface of the substrate at least one area
   a. outside of which the substrate is in the first state of the electron spin property, and
   b. inside of which the substrate is in one of the at least one second state of the electron spin property,
      or
   c. wherein the states of the electron spin property of the inside area and the outside area are inverted, and
III. wherein in step II.b a desired to be inside area is defined and delineated on the surface of the substrate which is in the first state of the electron spin property and wherein subsequently the surface in the defined and delineated inside area is contacted with a liquid which reacts with the substrate material to yield in or to bring about the transition into the at least one second state of the electron spin property within the inside area only,
   or
   wherein in step II.c the states of the electron spin property of the surface and the inside area are inverted, wherein
IV. the individual area of the at least one area has a size of <3 µm² and/or wherein multiple areas form one array or more arrays of areas of regular or irregular shapes of any size or sizes.

The process underlying the present invention has the advantage that no subtractive or additive steps are needed in making the mesosurface i.e. the composition of the mesosurface is contained entirely within the layer that is transitioned by the liquid. The process, therefore, is cheaper, and the surfaces are smoother than, for example, those formed with photolithography. Moreover, the mesosurface is dynamic, i.e. the electron spin property can be reversed or dynamically tuned by the inventive process. Another unique advantage of the new process is that it allows mesosurfaces to be formed readily on curved or flexible surfaces. Through various resist masks with tunable orifices with critical dimensions of <1µm in diameter (or a size of < 3µm²) up into the low hundreds of nm range, a wide range of magnetic spatial textures can be created, including an array or arrays of regular or irregularly shaped areas, e.g. checkerboard arrangements of ferromagnetic and antiferromagnetic phases as well as checkerboard structures composed only of two distinct antiferromagnetic phases. The boundaries between these regions can be just a few nanometers wide. Exemplary functional devices can be formed that are composed of spin ice structures that exhibit magnetic frustration and an operational magnetic racetrack device in which domain walls in wires can be very efficiently moved with current. The formation of complex magnetic mesostructures from homogeneous layers without the need for additive or subtractive processing using local ionic liquid gating is highly promising for a wide variety of functional magnetic spatial textures and spintronic devices. It has applications ranging from spin ice to magnetic logic and neuromorphic computing. Magnetic conduits for the controlled propagation of spin waves or magnetic racetracks that underly a novel, high performance non-volatile magnetic memory, are other examples of magnetic meso-structures.

### DEFINITION OF TERMS

Within the meaning of the present invention the following terms in parenthesis, whether used in singular or plural form shall have the following meaning:
"Mesosurfaces" exhibit a surface texture of delineated, distinguished physical properties on the meso-scale, which means that the delineated surface areas are in the "meso" range of between 10 nm² to 1000 µm². Mesosurfaces are to be distinguished from "metasurfaces" which are formed from periodic arrangements of matter, extended over a length scale that is typically several periods, whereas a mesosurface can be and typically are formed from an aperiodic arrangement of matter. The mesosurface can have a thickness of from a few nm to hundreds of nm.

"Substrate" or "phase change material" is a material, which undergoes a change in an electron spin property, such as a change in magnetic property. This change may be a change in the type of magnetic property selected from a first state of one of ferromagnetic, ferrimagnetic, anti-ferromagnetic, paramagnetic and diamagnetic property to a second state which is different from the first state and which is also selected from one of ferromagnetic, ferrimagnetic, anti-ferromagnetic, paramagnetic and diamagnetic property. The change may also be a change in degree of the magnetic property or a combination of both type and degree. The states may be chiral or achiral. The first and second state may be distinguished by their distinct chirality (e.g. clockwise or anti-clockwise) or these states may be distinguished by their domain structure, for example, the orientation of the magnetic domain along a certain direction. Thus, the substrate exhibits at least two distinct states of an electron spin property, which are all stable at ambient conditions (i.e. between 10 and 30 °C; between 950 and 1100 hPa).

The transition from one state of electron spin property to another is brought about by a change in the chemical composition of the substrate material, e.g. by its stoichiometric oxygen content. This transition may be instigated by applying an electric potential to a liquid in contact with the substrate.

One prime substrate is SrCoO₃. SrCoO₃ crystallizes as metallic ferromagnetic (FM) with a perovskite structure and exhibits two insulating antiferromagnetic (AF) counterparts, which exhibit a brownmillerite structure (formula: SrCoO_{2.5}). Thin layers of these compounds can be completely and reversibly transformed between each other by the addition or subtraction of oxygen via ionic liquid (IL) gating (see references14-16). This can take place through µm sized holes in a resist layer (see reference 17). The structure of the brownmillerite phase that is formed in this way consists of periodic layers of oxygen vacancies that are ordered either vertically at low gate voltage (V) or parallel to the substrate (P) above a threshold gate voltage that is applied to the IL during the gating process. These two oxygen vacancy ordered phases, V- and P-SrCoO_{2.5}, have distinct antiferromagnetic structures and properties. Taking advantage of these dual states stabilized by distinct gate voltages a series of magnetic meso-structures composed of regions formed from either of these two AF structures or the FM parent perovskite can be created. The regions can be of any arbitrary shape. Other substrate materials for the present invention, which undergo a change in an electron spin property with change in oxygen composition includes SrFeO₃, REFeO₃ (RE= La, Nd, Gd...).

"Electron spin property" or "State of electron spin property" means a magnetic property selected from one of ferromagnetic, ferrimagnetic, anti-ferromagnetic, paramagnetic and diamagnetic property. The property may also include a quantification, i.e. a degree of the magnetic property. The electron spin property can easily be determined and quantified using typical commercial measuring instruments.

Two otherwise identical substrate materials are in a different state of an electron spin property when they are measurably distinct from each other in this electron spin property. Measurably distinct means that the electron spin property varies by a statistically significant amount or factor, which is typical for the state transition in question.

"Transition" means that the material in question can be converted from one first state of electron spin property into at least one other second state of electron spin property, which is measurably distinct from the first state. The means for such a transition may be a change in pressure and/or temperature, the application of an electrical field, a chemical reaction etc.

"Stable" means that the state of electron spin property remains unchanged under ambient conditions for a minimum amount of time. Ambient conditions means between 10 and 30 °C and between 950 and 1100 hPa. A minimum amount of time means at least 100 days, preferably at least 1000 days, more preferably at least 10000 days.

"Reversibly" means that the transition from one first state of electron spin property into another second state of electron spin property can be reversed from the second state back into the first state.

An "area" created on a surface of the substrate is a part of the surface which is delineated from another part of the surface by a boundary of infinitesimal width. The area may form a closed area having a perimeter of infinitesimal width, which delineates the inside of the area from the outside of the area. Infinitesimal width means 1-100 nm, preferably 2-50 nm, more preferred 5-10 nm. The total of the delineated surface areas are in the "meso" range of between 10 nm² to 1000 µm². The critical dimension of an individual area is from <1µm in diameter into the low hundreds nm range. Also, the area can be construed of a wide range of magnetic spatial textures of deliberate size, including an array or arrays of regular or irregularly shaped areas, e.g. checkerboard arrangements of ferromagnetic and antiferromagnetic phases as well as checkerboard structures composed only of two distinct antiferromagnetic phases, or rectangularly shaped regions that can extend to wires.

"Array" means an aggregation of two or more identical or at least nearly identical shapes.
"yield in/bring about" the transition means that the applied liquid reacts with the substrate in a way that changes the chemical composition of the substrate material (=chemical reaction) so that the resulting chemical product in the area of contact is transitioned from a first state of electron spin property into another second state of electron spin property, which is measurably distinct from the first state. In an alternative embodiment or simultaneous to the chemical reaction a liquid can be used as an electrical conducting fluid allowing and/or aiding in the transport of electrons and/or ions to or from the substrate in the area of contact and/or to apply an electrical potential.

"Liquid" means a fluid medium, e.g. water, an alcohol like ethanol, methanol etc., a hydrocarbon like pentane, hexane etc., a halogen containing hydrocarbon like chloroform etc., which reacts with the substrate material to yield in or to bring about the transition into the at least one second state of electron spin property within the exposed inside area(s) only. In an alternative embodiment, the liquid can be an electrical conducting fluid allowing and/or aiding in the transport of electrons and/or ions to or from the substrate in the exposed area(s) of contact and/or to apply an electrical potential. One preferred liquid is an ionic liquid, which is an organic or inorganic liquid, which contains or consists of ions. Examples are aqueous solutions of organic or inorganic water soluble salts, e.g. NaCl, KCI, etc. or organic ionic liquids like 1-Ethyl-3-methylimidazolium bis(trifluoromethylsulfonyl)imide (EMIM-TFSI), 1-Propyl-3-methyl-imidazolium bis(trifluoromethylsulfonyl)imide, 1-Butyl-3-methylimidazolium bis(tri-fluoromethylsulfonyl)imide or 1-Hexyl-3-methylimidazolium bis(trifluoromethyl-sulfonyl)imide. These imidazolinium compounds are room temperature ionic liquids (RTIL). They are non-aqueous solvents, which are advantageous over traditional aprotic polar organic solvents in electrochemical reactions. They have a low vapor pressure, high thermal stability and good electrical conductivity. The liquid may have a viscosity from a freely flowing liquid to a highly viscous gel but a common property is the ability to accept or provide oxygen to the substrate.

### DETAILED DESCRIPTION OF THE INVENTION

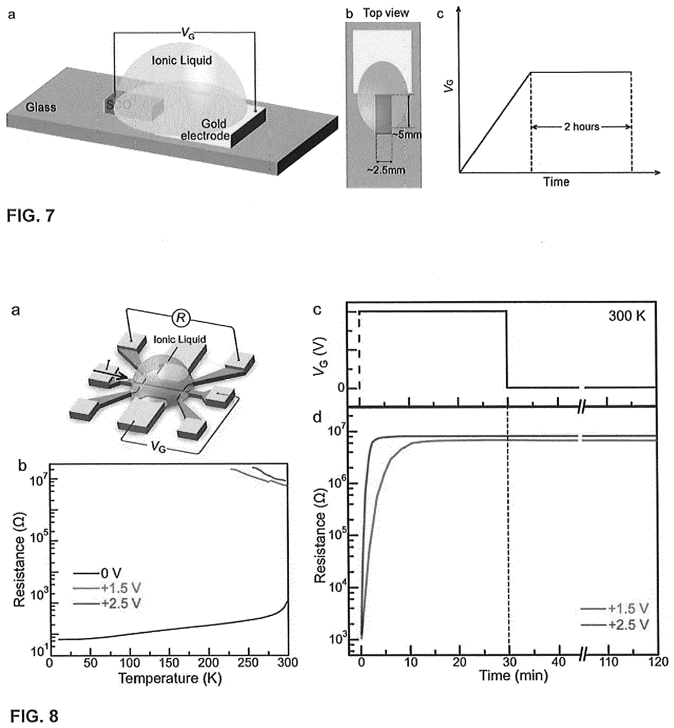

The process underlying the present invention transitions a surface of a substrate into a mesosurface. The process is able to create a wide range of magnetic spatial textures, including checkerboard arrangements of ferromagnetic and antiferromagnetic phases as well as checkerboard structures composed only of two distinct antiferromagnetic phases or stripes of ferromagnetic and antiferromagnetic phases for magnetic racetrack memory devices. Liquid gating, preferably ionic liquid gating (ILG), through a resist mask with holes, is used on a layer of a substrate (a phase change material) in order to locally create regions of an altered state of an electron spin property. The created regions may have various dimensions within the remaining areas of un-altered state of the electron spin property. The liquid, preferably the ionic liquid brings about a phase change, i.e. a change in an electron spin property in the local regions under the holes (see Fig. 7a and b). This approach is highly flexible, as it does not require physical (subtractive) patterning of the substrate material. This approach opens a way towards electrically reconfigurable mesomaterials.

The substrate itself is a two dimensional material of negligible thickness (a thin film). The thickness is typically in the range of 1-1000 nm, preferably 5-500 nm, more preferably 5-100 nm. The planar size of the substrate is typically in the range of 1-1000 mm², preferably 10-500 mm², more preferably 50-299 mm². Techniques such as chemical solution deposition (CSD), spin coating, chemical vapor deposition (CVD), plasma enhanced CVD, atomic layer deposition (ALD), molecular layer deposition (MLD), electron beam evaporation, molecular beam epitaxy (MBE), sputtering, pulsed laser deposition, cathodic arc deposition (arc-PVD) or electrohydrodynamic deposition can be used to manufacture the ultrathin films of substrate material. It is surprising that the films can even be up to about 1 µm thick and still the liquid gating, specifically ILG, at the film surface results in a dramatic change of the electron spin property in the entire thickness of the layer. This is a result of the diffusion of ions from within the interior of the film controlled by ILG. When the ionic diffusion occurs preferentially along certain crystallographic directions the cross-sectional area of the modified material is defined by the "hole" in the resist layer (the "mask").

Accordingly, it may be desirable for the transition from one state of electron spin property into another of the substrate to create the substrate surface in a preferred, predetermined direction of a crystallographic face expressed in terms of h,k,l-indices, e.g. the [100] direction, or the [001] direction, or the [111] direction etc.. This may be advantageous if e.g. the mobility of certain atoms in a certain direction of the unit cell ([h,k,l]) of the substrate material is higher/lower than in another direction.

Such a growth of the thin film in a predetermined direction can be facilitated by epitaxy, where the substrate of interest is grown on an "inducing" surface of a second material which exhibits a physical surface which matches the desired direction [h,k,l] of the to be grown substrate and which exhibits a crystallographic structure and unit cell dimensions which are at least similar, if not close to identical (so called "lattice matching"; i.e. unit cell axis and/or angle deviation of max. 10%, preferably max. 5%, more preferred max. 3%) to the one of the to be grown substrate material. Such epitaxy methods are known to the skilled person. It is also possible to form films that are predominantly of one crystal texture but which are not crystallographically oriented with respect to the substrate. This is often referred to as polycrystalline epitaxy. Polycrystalline films with one preferred crystal orientation perpendicular to the plane of the film can be formed by use of underlayers that themselves grow with a preferred crystalline orientation and that thereby induce the epitaxial growth of the thin film of interest.

In the next step, the defined and delineated inside areas are formed on the substrate surface. The shapes of the delineated areas can take any desired form, which is suitable for the kind of mesosurface to be manufactured. E.g., they can be arranged as checkerboards or stripes. The shapes are designed and arranged on the surface of the substrate material. The predesigned delineated area shapes on the surface in which the state of electron spin property shall be transitioned from its initial state to a measurably distinct at least second state can be created e.g. by applying lithographic techniques, i.e. by creating a structured mask which covers the to be modified surface of the substrate. Typical lithographic resists, suitable for exposure using light, electron beams or heat, can be used to cover the surface of the substrate in a thin layer (thickness: 100-1000 nm, preferably 150-750 nm, more preferred 200-400 nm).

Subsequently, the desired forms of the to be transitioned areas are cut out of the resist cover layer, thereby exposing the substrate surface in the cut out areas only. Cutting can be performed e.g. with precision electron beam lithography methods by use of modification of the chemical properties of the resist layer and their subsequent removal by dissolution by use of suitable chemical solvents. The resulting structures can have widths or radii that can be as small as ≤ 500 nm, preferably ≤ 100 nm, more preferred ≤ 50 nm.

In the next step the state of electron spin property of the exposed area(s) of the substrate surface is (are) transitioned from its initial state of electron spin property to a measurably distinct at least second state of electron spin property. During this step the surface in the defined and delineated exposed inside area(s) is (are) contacted with a liquid which reacts with the substrate material to yield in or to bring about the transition into the at least one second state within the exposed inside area(s) only. This process is called "liquid gating" since the liquid forms ion "gates" in the exposed surface area(s). The applied liquid reacts with the substrate in a way that changes the chemical composition of the substrate material (=chemical reaction) so that the resulting chemical product in the area(s) of contact (the exposed area(s)) is (are) transitioned from a first state of electron spin property into another second state of electron spin property. In an alternative embodiment or simultaneous to the chemical reaction the liquid can be used as an electrical conducting fluid allowing and/or aiding in the transport of electrons and/or ions to or from the substrate in the exposed area(s) of contact and/or to apply an electrical potential. One preferred liquid is an ionic liquid, which is an organic or inorganic liquid, which contains or consists of ions. Examples are aqueous solutions of organic or inorganic water soluble salts, e.g. NaCl, KCl, etc. or organic ionic liquids like 1-Ethyl- 3-methylimidazolium bis(trifluoromethylsulfonyl)imide (EMIM-TFSI), 1-Propyl-3-methyl-imidazolium bis(trifluoromethylsulfonyl)imide, 1-Butyl-3-methylimidazolium bis(tri-fluoromethylsul-fonyl)imide or 1-Hexyl-3-methylimidazolium bis(trifluoromethyl-sulfonyl)imide. These imidazolinium compounds are room temperature ionic liquids (RTIL). They are non-aqueous solvents, which are advantageous over traditional aprotic polar organic solvents in electrochemical reactions. They have a low vapor pressure, high thermal stability and good electrical conductivity.

In one embodiment, where the exposed area(s) is(are) contacted with an ionic liquid the transition of state of electron spin property is preferably performed by simultaneously applying an electric voltage of 0.1-10 Volts, preferably 1-5 Volts, more preferred 2-3 Volts. In the case of applying an electric voltage, the voltage is applied against a counter electrode, which is also in contact with the ionic liquid. A preferred material for the counter electrode is a metal, more preferred a metal like Fe, Co, Ni, Pd, Pt, Cu, Ag, Au or Zn, most preferred Ag or Au or Pt.

The reaction time of the liquid with the exposed area(s) is preferably from 1 second to 10 hours, preferably from 1 minute to 1 hour, more preferred from 10 minutes to 40 minutes.

After completion of the transition the structured resist cover layer may be removed by known techniques, e.g. washing with a solvent and the obtained mesosurface can be dried.

### Brief description of figures

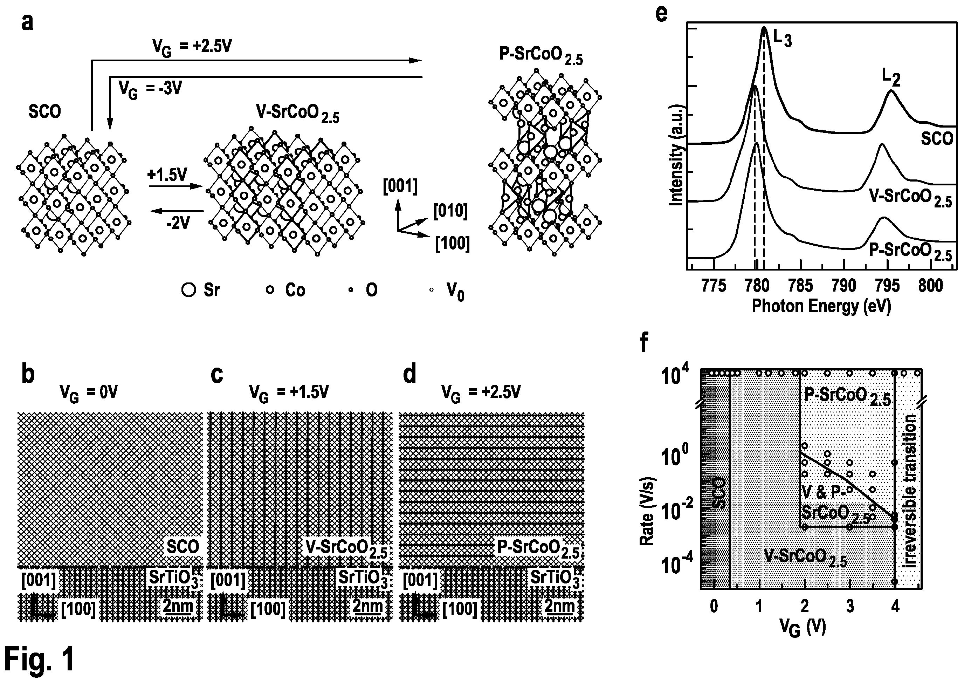

**Figure 1**
   Ionic liquid gate controlled phase transitions in SrCoOₓ
      **a** Sketch of the IL induced reversible phase transition between SrCoO₃ (SCO) and *V*-SrCoO_{2.5} or *P*-SrCoO_{2.5}
   Cross-section STEM-HAADF images of:
      **b** SCO
      **c** *V*-SrCoO_{2.5}
      **d** *P*-SrCoO_{2.5}
      All images in Figures 1 b, c, and d projected along [100]. In the HAADF imaging mode, the atomic column intensity is approximately proportional to *Z*² (*Z* is the atomic number), so that the brighter and darker columns are the Sr and Co cations, respectively
         **e** XAS of SCO, *V*-SrCoO_{2.5} and *P*-SrCoO_{2.5}
         **f** Phase diagram of the SCO-SrCoO_{2.5} system versus *V_{G}* and *R_{G},* as determined by XRD measurements
**Figure 2**
   Oxygen planar defects in SrCoOₓ
   Cross-section STEM-ABF images of:
      **a** SCO,
      **b** *V*-SrCoO_{2.5}
      **c** *P*-SrCoO_{2.5}
   All images in Figures 2 a, b and c are projected along [110]. The ABF images are more sensitive to low-Z elements such as oxygen so that the contrast is opposite to that in the HAADF images.
   CoO*ₓ* intensity profiles for:
      **d** SCO
      **e** *V*-SrCoO_{2.5} and
      **f** *P*-SrCoO_{2.5}
   The intensity profiles are taken from the areas marked by the dashed boxes in the corresponding ABF image. The Sr, Co, O, and oxygen vacancy sites (*Vo*) are indicated by yellow, red, green spheres, and green circles, respectively.
**Figure 3**
   Ionic liquid gating effect on magnetic structure
      **a** *M*-*T* curve of SCO, *V*-SrCoO_{2.5}, and *P*-SrCoO_{2.5} at 10 K
      **b** *M*-*H* curves of SCO, *V*-SrCoO_{2.5}, and *P*-SrCoO_{2.5} at 10 K
      **c** *H*_{EB} measured at 10 K for *V*-SrCoO_{2.5}/LSMO and *P*-SrCoO_{2.5}/LSMO as a function of the in-plane angle *ϕ* between *H* and [010]
      **d** *M*-*H* curves at 10 K for *V*-SrCoO_{2.5}/LSMO (*ϕ* = 0°, [010] direction) and *P-*SrCoO_{2,5}/LSMO (*ϕ* = 45°, [110] direction)
      **e** XMLD (in total electron yield mode) of V-SrCoO_{2.5} and *P*-SrCoO_{2.5} for various *ϕ*. A sketch of the XMLD measurement setup is shown in the inset.
   Total energy for:
      **f** *V*-SrCoO_{2.5} and
      **g** *P*-SrCoO_{2.5}
   of a 2×2×4 cell for three *AF* configurations *(A-, C*-, and *G*-type) as a function of seven different Co moment directions. Sketches of the *AF* spin configurations for *V*-SrCoO_{2.5} and *P*-SrCoO_{2.5} crystals are shown in the insets where the Co moment directions are indicated by arrows. The Sr, Co, O, and oxygen vacancy (Vo) sites in the sketches are indicated by yellow, red, green spheres, and green circles, respectively.
**Figure 4**
   Creation of SrCoOₓ mesostructures
   **a** Sketch of the creation of a SrCoOₓ mesostructured
   **b** Typical cAFM images,
   **c** Overview and
   **d** Enlarged TEM images for a SCO/*V*-SrCoO_{2.5} (V) checkerboard mesostructure. This mesostructure is made by IL gating at *V*_{G} = +1.5 V of a SCO film through a resist mask that has several sets of orifices in the form of checkerboards.
   **e** Typical cAFM images
   **f** Overview and
   **g** Enlarged TEM images for a *P*-SrCoO_{2.5} (P)/*V*-SrCoO_{2.5} (V) checkerboard mesostructure. The enlarged TEM images of **d** and **g** are taken from the areas marked by the frames in **c** and **f,** respectively. This sample is made by IL gating of a SCO/*V-*SrCoO_{2.5} (V) mesostructured without any resist mask at *V*_{G} = +2.5 V.
**Figure 5**
   SrCoO₃/V-SrCoO_{2.5} magnetic textures
      **a** Kerr image of SCO/*V*-SrCoO_{2.5} magnetic texture at 100 K without external magnetic field **b** Kerr loops of areas marked by black and red frames in **a** MFM images of SCO/*V*-SrCoO_{2.5} magnetic texture:
      **c** 200×200 nm² checkboard and
      **d** 600×200 nm² nanomagnets formed in a hexagonal array
   The FM and AF parts are indicated by black and red frames in **c.** The desired patterns of the nanomagnets are marked by red frames in **d.** All the samples are made by IL gating on SCO sample through resist mask at *V*_{G} = +1.5 V.
**Figure 6**
   Magnetic racetrack formed by IL gating through a resist mask (embodiment of the invention)
   **a** Kerr image of racetrack device that has a width of 4 µm that is formed by resist-mask IL gating (*V*_{G} = +1.5 V for 2 hours) of a SCO film. The images are taken at 76.5 K in the presence of a magnetic field of 16.7 kA/m (210 Oe) oriented in-plane along the racetrack channel to improve the MOKE contrast. Inset is the cAFM image at 300 K for an area including the racetrack (measured on a similar sample that was grown on a Nb-doped STO).
   **b** a sequence of Kerr microscope images of a single domain wall moved along the *FM* SCO wire by current pulse sequences formed from ten 20 ns long pulses; the current density is 1.07×10⁷A/cm². No field is applied. Blue and red arrows indicate the current direction.
   **c** the domain wall velocity as a function of current pulse density *J* at 76.5 K and 124.4 K.
**Figure 7**
   Ionic liquid (IL) gating
   **a, b**Schematic diagram of ionic liquid (IL) gating for *ex-situ* experiments
   **c** Time evolution of gate voltage (*V*_{G}) during the gating procedure
**Figure 8**
   Nonvolatility of ionic liquid gating effect on transport properties
   **a** Hall bar formed by standard photolithography and argon ion milling procedures. The Hall bar is 100 µm wide and 450 µm long. A large lateral electrode is formed by lift off techniques.
   **b** Temperature dependence of the resistance of a typical SCO film in the pristine state (*V*_{G} = 0 V) and after gating at *V*_{G} = +1.5 V and +2.5V for 30 min. The pristine metallic SCO phase is transformed to an insulating state after these gating procedures.
   **c** *V*_{G} and
   **d** channel resistance versus time when *V*_{G} = +1.5 V and +2.5 V are applied at a rate of 10⁴ V/s. Gate voltages are applied for 30 min and then removed. The resistance in both cases remains constant after *V*_{G} is removed, proving the nonvolatility of IL gating effect. Data for 90 min after *V*_{G} is set to zero are shown but the non-volatile state remains indefinitely.
**Figure 9**
   Nonvolatility and reversibility of IL gating effect revealed by XRD
   **a** Specular XRD patterns of pristine SCO (*V*_{G}=0 V) and samples gated by *V*_{G} = +1.5 V and +2.5 V. *V*_{G} of +1.5 V and +2.5 V drive the perovskite type SCO to brownmillerite SrCoO_{2.5} phase with oxygen vacancy planes vertical (*V*) and parallel (*P*) to the surface, labelled as *V*-SrCoO_{2.5} and *P*-SrCoO_{2.5}, respectively. XRD patterns of gated samples were recorded twice, namely (i) 20 min and (ii) 10 days after removal of *V*_{G} as labelled in the figure. Their reproducibility indicates that the IL gating effect is nonvolatile.
   **b** Specular and
   **c** non-specular XRD patterns for samples subject to different *V*_{G} application procedures: +2.5 V→ - 3 V, +1.5 V→ - 2 V, and +1.5 V → - 2 V→ +2.5 V. At each voltage *V*_{G} is applied for 2 hours. The *V*- and *P*-SrCoO_{2.5} structures can be transformed back to the pristine perovskite SCO phase by applying negative *V*_{G}. A film gated at +1.5 V (*V*-SrCoO_{2.5}), was transformed to *P*-SrCoO_{2.5} by first applying a *V*_{G} of -2V to transform the film first back to SCO and then followed by *V*_{G} = +2.5 V to enable the transformation to the *P*- phase.
**Figure 10**
   Creation of SrCoO*ₓ* mesostructures
   Conducting atomic force microscopy (cAFM) images of:
      **a** stripe SCO/*V*-SrCoO_{2.5} meso-structures, and
      **b** checkerboard SCO/*V*-SrCoO_{2.5} meso-structures
      **c** stripe *V*-SrCoO_{2.5}/*P*-SrCoO_{2.5} meso-structures, and
      **d** checkerboard *V*-SrCoO_{2.5}/*P*-SrCoO_{2.5} meso-structures.

### EXAMPLES

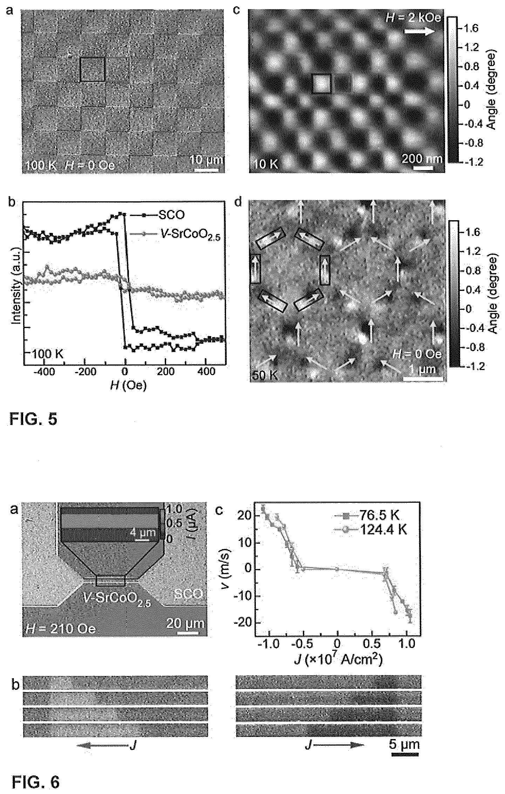

The invention will now be described by way of an embodiment of the invention (Fig. 6) and examples explaining the underlying technique.

The above described method of manufacture of a mesosurface is demonstrated using the metallic ferromagnetic (*FM*) perovskite SrCoO₃ and its twin counterpart, the insulating antiferromagnetic (*AF*) brownmillerite SrCoO_{2.5}. It is known that thin layers of these compounds can be completely and reversibly transformed between each other by the addition or subtraction of oxygen via ionic liquid (IL) gating (see references 14-16). It was also shown that this can take place through µm sized holes in a resist layer (see reference 17). For the present invention it is shown that these transformations can take place through holes in a resist layer that are twenty times smaller, as small as 100 nm in size or even lower. The structure of the brownmillerite phase that is formed in this way, consists of periodic layers of oxygen vacancies that are ordered either vertically at low gate voltage (*V*) or parallel to the substrate (*P*) above a threshold gate voltage that is applied to the IL during the gating process. These two oxygen vacancy ordered phases, *V*- and *P*-SrCoO_{2.5}, have distinct antiferromagnetic structures and properties. Taking advantage of these dual states stabilized by distinct gate voltages one can create a series of magnetic meso-structures composed of regions formed from either of these two *AF* structures or the *FM* parent perovskite. The regions can be of any arbitrary shape.

SrCoO₃ (SCO) films, 40 nm thick, were prepared by pulsed laser deposition on (001) SrTiO₃ (STO) substrates. IL gating of these films was carried out in devices that are shown schematically in Fig. 7a and b. Lateral gate electrodes formed from Au were used to apply a gate voltage (*V*_{G}) to the IL and thereby to transform the SCO film. This process, depending on the sign of *V*_{G} adds or subtracts oxygen from the SCO film in a non-volatile manner.

A thin film SCO/STO sample was cut into two halves, one of which was gated at *V*_{G} = 1.5 V and the other at 2.5 V. The voltage was increased from zero at a controlled and constant rate of *R*_{G} = 10⁴ V/s until the target *V*_{G} was reached where it was maintained constant for 2 hours (see Fig. 7c). The resulting gated films exhibit two distinct crystal structures, as schematically shown in Fig. 1a, and as revealed by cross-sectional scanning transmission electron microscopy-high angle annular dark field (STEM-HAADF) images in Fig. 1c and d. A comparison with the structure of the ungated film shown in Fig. 1b clearly shows dramatic structural changes.

The pristine SCO film has a uniform perovskite structure (Fig. 1b). In this image the bright and dark columns are the Sr and Co cations, respectively, since the atomic column intensity is approximately proportional to *Z²* (*Z* is the atomic number) in the HAADF imaging mode. By contrast the HAADF image for the *V*_{G} = +1.5 V sample shows dark columns along the *vertical* [001] direction indicating a superstructure which involves a doubling of the *a*-lattice parameter along [100] (see Fig. 1c). A different superstructure is found for the *V*_{G} = +2.5 V sample in which dark rows can be observed *parallel* to [100], the surface of the STO substrate (Fig. 1d): this corresponds to a quadrupled c-lattice parameter along [001] (see Table 1).

**Table 1**

| Materials | a (Å) | b (Å) | c (Å) |
|---|---|---|---|
| SCO | 3.91 | 3.90 | 3.80 |
| V-SrCoO2.5 | 7.94 | 3.86 | 3.81 |
| P-SrCoO2.5 | 3.91 | 3.90 | 15.76 |

Such superstructures are typical of ordered oxygen vacancy planes in brownmillerite phases: the planes containing oxygen vacancies appear darker than the stoichiometric planes in the HAADF images. The superstructures observed show that positive gate voltages create oxygen planar defects in the SCO thin film and, more importantly, that the orientation of these defects can be manipulated by the magnitude of *V*_{G}. In bulk material the *P* phase is typically observed and this same phase has previously been detected in thin films grown on STO but the present invention for the first time provides a route to form the *V* phase on STO. Thus, IL gating provides a novel route to the controlled formation of both of these phases.

The chemical composition of the samples was studied by X-ray absorption spectroscopy (XAS). The Co-*L*₃ peaks for both *V*_{G} = +1.5 V and +2.5 V shift to a lower photon energy (by ~1.1 eV), as compared to pristine SCO, indicating the Co valence is reduced by ~1 e⁻ (Fig. 1e). Thus, the corresponding stoichiometries of both the *V* and *P* phase are close to SrCoO_{2.5}. The three phases, SCO, V-SrCoO_{2.5} and *P-*SrCoO_{2.5}, can be unambiguously identified from their x-ray diffraction patterns (XRD).

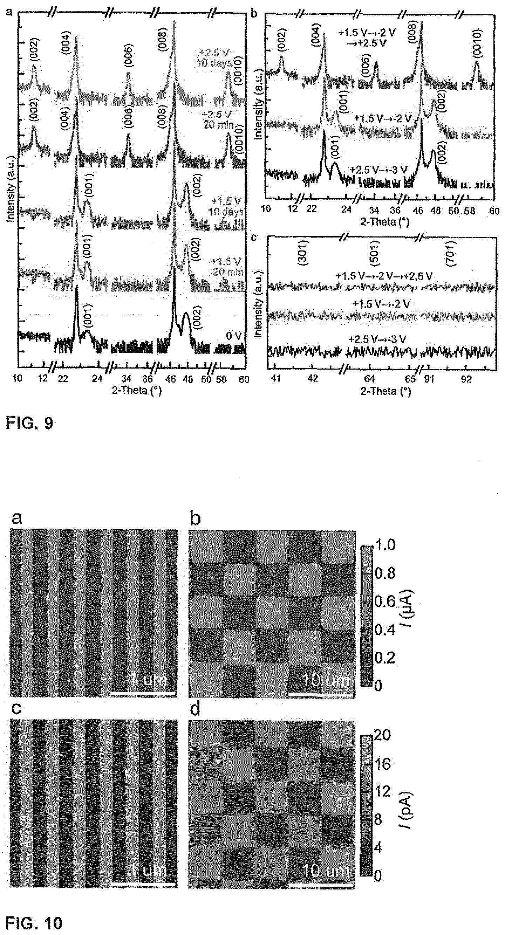

In addition to the magnitude of *V*_{G}, the rate of increase of *V*_{G} during the gating process was also varied. This allows for the phase stability diagram of SrCoO*ₓ* to be defined with respect both to *V*_{G} and *R*_{G}. When *R*_{G} is sufficiently large, and when *V*_{G} lies between +0.4 V and +1.9 V, SCO is transformed to *V*-SrCoO_{2.5}, but when *V*_{G} > +1.9 V (but below +4.2 V, above which the sample undergoes irreversible structural changes), rather *P*-SrCoO_{2.5} is formed. However, the situation completely changes when *R*_{G} < 2×10⁻³ V/s, under which conditions only the *V*-SrCoO_{2.5} phase is found, no matter how large is *V*_{G}. At these low rates, the sample has sufficient time to undergo a complete transformation to the V phase before *V*_{G}^{Crit} = +1.9 V is reached (see Fig. 8b). Any further increase in *V*_{G} beyond *V*_{G}^{Crit} does not induce a phase transition from Vto P. In order to realize such a phase transformation, it is necessary to transform the structure from *V*-SrCoO_{2.5} back to SCO by applying a sufficiently large negative *V*_{G} followed by the application of a suitably large positive *V*_{G} (see Fig. 9). For 2×10⁻³ V/s < *R_{G}* < 5×10⁻¹ V/s, a mixture of both the *V* and *P* phases are observed when *V*_{G} exceeds *V*_{G}^{Crit} (see Fig. 1f).

STEM-ABF (annular bright-field) images recorded along the [110] zone axis that is rotated by 45° as compared to the HAADF images discussed above, allows for the detailed determination of the positions of both the oxygen ions and vacancies, as shown in Fig. 2a-c. The ABF images are sensitive to low-Z elements such as oxygen. In the corresponding intensity line profiles of the CoO*ₓ* sublayers (Fig. 2d-f), the Co and filled O sites are seen as deeper and shallower troughs, respectively, while the oxygen vacancy sites are identified by broad peaks (in Fig. 2f). The ABF images of SCO and *V*-SrCoO_{2.5} look similar (Fig. 2a and b), but the corresponding intensity profiles within a CoO*ₓ* sub-layer in *V*-SrCoO_{2.5} (Fig. 2e) show shallower O troughs, as compared with those in SCO (Fig. 2d). Since the oxygen vacancies within the (100) plane of *V*-SrCoO_{2.5} are imaged along the [110] zone, each imaged O column has 25% O vacancies and thus a resultant higher ABF intensity. The CoO₂ sublayer in *P-*SrCoO_{2.5} shows an intensity profile similar to that of SCO (compare Fig. 2f to Fig. 2d). On the other hand, one can clearly see the pairing of the Co atoms within the oxygen deficient CoO sublayer in *P*-SrCoO_{2.5} that results from the ordering of the oxygen vacancies (see Fig. 2c). The columns of oxygen vacancies (marked by green circles) are located between the Co-Co pairs in each CoO sublayer, which can be clearly seen as peaks in the CoO sub-layer intensity profile (Fig. 2f).

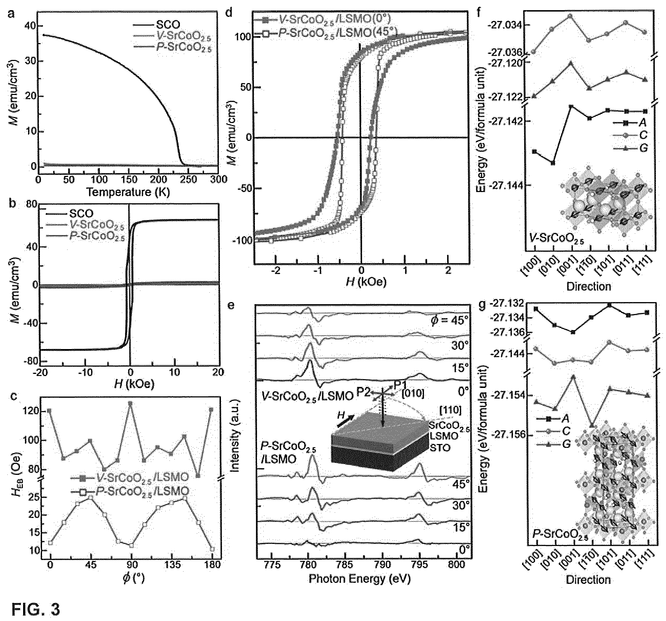

The magnetic properties of *V*-SrCoO_{2.5} and *P*-SrCoO_{2.5} were investigated experimentally and theoretically, which, owing to their distinct crystal structures, are also expected to differ. Temperature dependent magnetization (*M*-*T*) curves monitored in-plane along the [010] direction of the substrate are shown in Fig. 3a. These data show that SCO is a ferromagnet with a Curie temperature (*Tc*) of ~230 K. By contrast, both *V*- and *P*-SrCoO_{2.5} do not show any evidence for FM behavior but are rather consistent with *AF* behavior with Néel temperatures (*T*_{N}) of 323 K and 316 K, respectively.

M vs field (*H*) hysteresis loops of all three samples at 10 K are shown in Fig. 3b, where only pristine SCO shows a typical *FM* loop.

The hysteresis loops of both heterostructures of *V*- and *P*-SrCoO_{2.5} were measured along different in-plane directions, *ϕ*, the angle between *H* and STO [010], at 10 K after cooling in an in-plane *H* = 159.2 kA/m (2 kOe) for each measurement. The loops are shifted from zero field by an exchange bias field (*H*_{EB}). The angular dependence of *H*_{EB} is compared for the *V* and *P* phases in Fig. 3c. Peaks in *H*_{EB} are found at *ϕ* = 0°, 90°, and 180°, for *V*-SrCoO_{2.5}/ La_{0.7}Sr_{0.3}MnO₃ (LSMO) but at *ϕ* = 45° and 135° for *P*-SrCoO_{2.5}/LSMO. It is noteworthy that the maximum magnitude of *H*_{EB} is about 5 times larger for *V-*SrCoO_{2.5}/LSMO than for *P*-SrCoO_{2.5}/LSMO (Fig. 3d) and along different crystallographic directions. These substantial differences suggest the *AF* structures in these phases are distinct.

The *AF* structures were probed using x-ray magnetic linear dichroism (XMLD) in the vicinity of the Co-*L*_{2,3} absorption edge. XMLD is the difference in absorption of an incident x-ray beam that is linearly polarized in two orthogonal directions P1 and P2, as shown in the inset to Fig. 3e. Prior to the measurements, the samples were heated to 400 K followed by in-plane field cooling (159.2 kA/m (2 kOe)) in different angular directions (*ϕ*) to 300 K, the measurement temperature (see inset to Fig. 3e). P1 is set along the cooling field direction. The XMLD amplitude is related to the difference in the magnitude of the *AF* moment that is parallel to P1 and P2. Thus, the larger the amplitude of the XMLD, the more the Co moments are oriented along P1 or P2. As *ϕ* is varied between 0° and 45°, the XMLD signal from *V*-SrCoO_{2.5} continuously diminishes, which suggests that the easy axis of the Co moments is along [010]. By contrast, the continuously increasing XMLD signal in *P*-SrCoO_{2.5} shows that the [110] (45°) direction corresponds to the *AF* easy axis in this case. Thus, the *AF* easy axes for *V*-SrCoO_{2.5} and *P*-SrCoO_{2.5} are different and are parallel to the STO [010] (*ϕ* = 0°) and [110] (*ϕ* = 45°) directions, respectively. These findings are in good agreement with the angle dependent *H*_{EB} studies discussed in Fig. 3c. As both V- and *P*-SrCoO_{2.5} films grow in two rotational domains on the STO substrate, that are oriented at 90° to each other, the angular period of the *H*_{EB} oscillation is equal to 90° but not 180°, which would otherwise be the case for a single domain.

First principles calculations of the ground state energy of both *V*-SrCoO_{2.5} and *P-*SrCoO_{2.5} using a 2×2×4 supercell for three *AF* configurations, namely *A-, C-,* and *G-*type, were carried out. The total energy is displayed versus different orientations of the Co moments in Fig. 3f and g, respectively. In *V*-SrCoO_{2.5}, the A-type *AF* configuration with the Co moments along [010] has the lowest energy. By contrast, the G-type *AF* structure with a [110] easy axis is preferred for *P*-SrCoO_{2.5} which is in agreement with neutron powder-diffraction results on bulk material. The *AF* spin configurations of V-SrCoO_{2.5} and *P*-SrCoO_{2.5} are sketched in the insets to Fig. 3f and g, respectively. The calculations are consistent with the easy axis moment directions found from XMLD studies. The calculations also appear to be consistent with the experimental observation that *H*_{EB} is larger in *V*-SrCoO_{2.5}. An A-type *AF* ordering in *V*-SrCoO_{2.5} shows an uncompensated moment at its surface which should therefore result in a stronger *H*_{EB} as compared with that of the G-type *AF* ordering in *P*-SrCoO_{2.5} whose surface moment is fully compensated.

### Manufacture of engineered electric and magnetic meso-structures

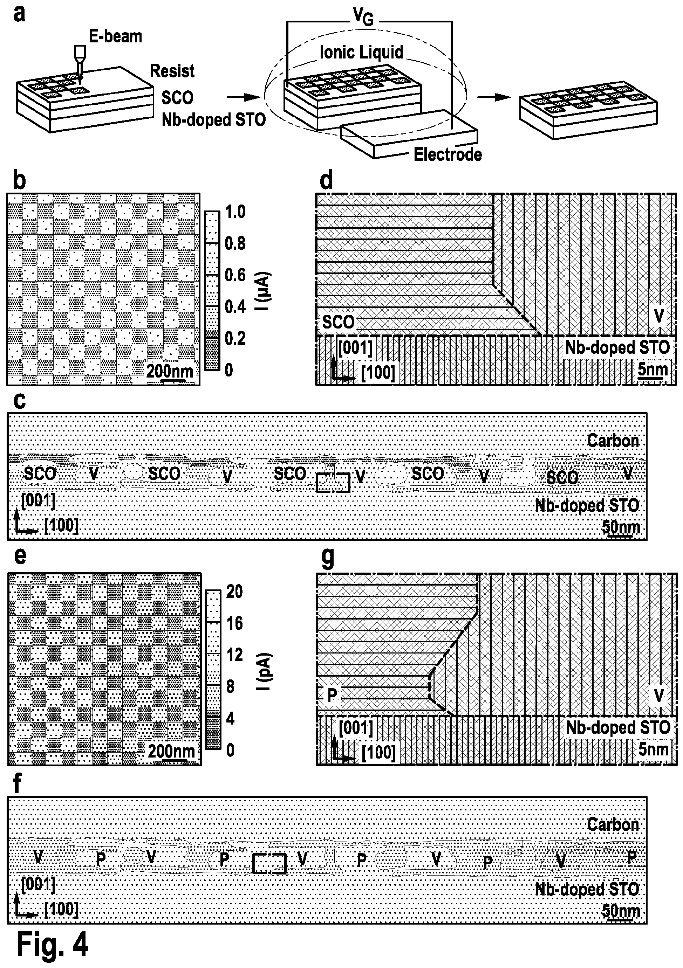

Several magnetic spatial meso-textures were formed from both metallic *FM* SCO and the two insulating *AF* SrCoO_{2.5} phases that can be formed by IL gating As mentioned above µm sized SCO circular regions could already be formed in a layer of *P-*SrCoO_{2.5} by local liquid gating (see reference 17). In this case, however, the boundary between these phases was quite broad due to substantial oxygen ion diffusion parallel to the substrate. Using resist masks with much smaller orifices, as small as ~50 nm, that are spun on top of a SCO layer and patterned by electron beam lithography, regions of one or the other of the *AF* phases can be formed by applying positive voltages below or above *V_{G}* to an IL that is placed on top of the resist mask, as illustrated in the sketch in Fig. 4a. An example in which a checkerboard pattern of the *V* phase is formed in an initial uniform SCO layer is given in Fig. 4b-d. The local structure within the checkerboard has dimensions of ~100×100 nm² and the overall pattern was 20×20 µm² in area. After IL gating and the removal of the resist layer, cAFM (conducting atomic force microscopy) is used to image the patterned structure by taking advantage of the substantially different conductivities in the SCO and V phases. The cAFM image matches perfectly the resist mask clearly demonstrating that the SCO was transformed to the *V* phase only within the tiny orifices. The structural transformation was confirmed by TEM analysis as shown in Fig. 4c in which dark and bright regions alternate along the [100] direction, one axis of the checkerboard pattern. A magnified TEM image in Fig. 4d shows that these regions have distinct structures of in the one case the perovskite SCO phase and in the other the *V*-SrCoO_{2.5} (V) phase. The dimensions of these regions, of ~100 nm, are consistent with the cAFM images shown in Fig. 4b. The boundary between the SCO and *V*-SrCoO_{2.5} region is very sharp (only ~6 nm wide).

### Manufacture of a magnetic meso-structure formed from the two AF SrCoO_{2.5} phases

The two *AF* SrCoO_{2.5} phases are formed at different IL gate voltages. First the same spatial texture as in Fig. 4b is formed. Then after the removal of the resist layer a second IL gating procedure is carried out without any resist mask at a higher *V*_{G} = +2.5 V. cAFM and TEM images for the resulting meso-structure are shown in Fig. 4e-g. After this second IL gating, the previous metallic regions become highly insulating (the maximum leakage current is less than 20 nA) but, nevertheless, a checkerboard structure with distinct conductivities is visible (Fig. 4e). In the corresponding TEM images, one can now see a superstructure consisting of *V*-SrCoO_{2.5} (V) and *P-*SrCoO_{2.5} (P) phases, respectively (Fig. 4f and g). This means that the *V*-SrCoO_{2.5} phase is not directly changed to *P*-SrCoO_{2.5} phase even when a large *V*_{G} is applied (which is consistent with the phase diagram given in Fig. 1f).

Using the same techniques a wide variety of magnetic meso-structures can be formed from any of the *FM* SCO and the *AF V*-SrCoO_{2.5} and *P*-SrCoO_{2.5} phases. In Fig. 10 several more examples are given where meso-structures were created with length scales varying from 10 µm to 200 nm in the form of checkerboards and stripes. The large area checkerboards (see Fig. 5a) allowed the local magnetic properties to be studied using magneto-optical Kerr microscopy (MOKE) that confirmed the ungated SCO regions were magnetic, as shown in Fig. 5b. Mesostructures with smaller feature sizes were studied with variable temperature magnetic force microscopy (MFM). An MFM image of a 200×200 nm² checkerboard mesostructure is given in Fig. 5c.

To explore functional devices a periodic hexagonal array of elongated nanomagnets (600×200 nm²) was made using the same procedures as discussed above, as shown in Fig. 5d. In this way a spin ice structure could be formed from an initial uniform SCO layer. The magnetic frustration between the hexagonally arranged nanomagnets can clearly be seen in the MFM image shown in Fig. 5d.

Finally, according to an embodiment of the present invention, a "magnetic racetrack" was formed again from an initial uniform SCO film. In this case the resist mask is used to define magnetic stripes that form the racetracks, as can be seen very clearly in the MOKE image shown in Fig. 6a. cAFM (inset to Fig. 6a) also confirms that metallic magnetic racetracks have been formed in an insulating matrix. Although the SCO is only ferromagnetic below ~230 K, nevertheless, the current induced motion of magnetic domain walls in the SCO racetracks is possible, as demonstrated in Fig. 6b at temperatures of 76.5 K and 124.4 K. The domain walls can be moved at velocities of up to ~22.7 m/s at 76.5 K using a current density of only *J* = 1.07×10⁷ A/cm². The SCO racetracks have high resistivities of ~8.4×10⁻⁶ Ωm at 76.5 K and ~1.0×10⁻⁵ Ωm at 124.4 K and, therefore, cannot sustain higher current densities. However, the efficiency of driving the domain walls in these SCO racetracks with current is higher even than the fastest domain wall speeds reported to date that rely on a bulk spin-transfer torque mechanism.

### METHODS

### Sample preparation

SCO thin films, 40 nm thick, were grown on STO (001) substrates at 725 °C, in an oxygen pressure (*p*_{O}) of 2×10⁻¹ mbar, using pulsed laser deposition (PLD). The growth temperature and po for La_{0.7}Sr_{0.3}MnO₃ (LSMO) were 600 °C and 2×10⁻¹ mbar, respectively. Undoped and 0.5 wt % Nb doped single side polished STO substrates were used. After deposition, the SCO films and the SCO/LSMO heterostructures were cooled to room temperature in an oxygen atmosphere of 500 mbar. The IL N,N-diethyl-N-(2-methoxyethyl)-N-methylammonium bis(trifluoromethylsul-fonyl)-imide (DEME-TFSI), was used for all gating experiments. The IL and the devices were separately baked at 130 °C in high vacuum (10⁻⁷ mbar) for at least 12 hours before the gating experiments were carried out. The resist masks were prepared by electron beam lithography (Raith Nanofabrication system) using a positive resist CSAR (APR6200.09 ~200 nm thick). Large area thin films were gated in a probe station (pressure <10⁻⁶ mbar). All the measurements were carried out *ex-situ* after removing the IL and any resist. Devices for transport measurements were prepared by photo-lithography and wet etching in the form of Hall-bars. Electrical contacts were formed from Au (60 nm)/Cr (10 nm) that were deposited by thermal evaporation.

### Sample characterization

An FEI Titan 80-300 microscope, which is probe-corrected to achieve a point-to-point resolution of ~1 Å, was used for the (S)TEM studies. The convergence semi-angle for STEM-HAADF imaging was ~22 mrad, while the collection semi-angle was 70-176 or 200 mrad for STEM-HAADF imaging, and 12-24 mrad for STEM-ABF imaging. XRD measurements were carried out using a Bruker AXS D8 ADVANCE x-ray four circle diffractometer. The magnetic properties (*M*-*H* curves at 10 K and *M*-*T* curves from 400 to 10 K) were carried out using a Superconducting quantum interference device-vibrating sample magnetometer (SQUID-VSM). The XAS and XMLD measurements in total electron yield (TEY) mode were performed at Beamline BL08U1A at the Shanghai Synchrotron Radiation Facility (SSRF). The transport properties in Hall bar devices were measured in a Quantum Design DynaCool. All the characterization and transport experiments, unless otherwise specified, were carried out at 300 K.

### First-principle calculations

First-principle calculations were carried out with the projector augmented wave implementation of the Vienna *ab initio* simulation package (VASP). A generalized gradient approximation plus *U* (GGA+*U*) was used as the energy functional, with a setting of the Coulomb repulsion *U* = 4.5 eV and the exchange interaction *J* = 1.0 eV for the Co *d* electrons. A 2×2×4 supercell was used for SrCoO_{2.5} for both the vertical and parallel superstructures. All the structures are optimized with a cutoff energy of 550 eV and appropriate *k*-point meshes both of which were increased until convergence.

### References

1. Shukla, S., Deheri, P. K. & Ramanujan, R. V. Magnetic nanostructures: synthesis, properties, and applications. Springer Handbook of Nanomaterials. Springer Berlin Heidelberg: Berlin, Heidelberg, 2013, pp 473-514.
2. Martin, J. I., Nogués, J., Liu, K., Vicent, J. L. & Schuller, I. K. Ordered magnetic nanostructures: fabrication and properties. J Magn. Magn. Mater. 256, 449-501 (2003).
3. Wolf, S. A. et al. Spintronics: a spin-based electronics vision for the future. Science 294, 1488-1495 (2001).
4. Chumak, A. V., Vasyuchka, V. I., Serga, A. A. & Hillebrands, B. Magnon spintronics. Nature Phys. 11, 453-461 (2015).
5. Grollier, J., Querlioz, D. & Stiles, M. D. Spintronic nanodevices for bioinspired computing. Proc. IEEE 104, 2024-2039 (2016).
6. Nisoli, C., Moessner, R. & Schiffer, P. Colloquium: Artificial spin ice: Designing and imaging magnetic frustration. Rev. Mod. Phys. 85, 1473-1490 (2013).
7. Torrejon, J. et al. Neuromorphic computing with nanoscale spintronic oscillators. Nature 547, 428-431 (2017).
8. Wang, Y. et al. Magnetization switching by magnon-mediated spin torque through an antiferromagnetic insulator. Science 366, 1125-1128 (2019).
9. Han, J., Zhang, P., Hou, J. T., Siddiqui, S. A. & Liu, L. Mutual control of coherent spin waves and magnetic domain walls in a magnonic device. Science 366, 1121-1125 (2019).
10. Parkin, S. S. P., Hayashi, M. & Thomas, L. Magnetic domain-wall racetrack memory. Science 320, 190-194 (2008).
11. Parkin, S. & Yang, S.-H. Memory on the racetrack. Nature Nanotechnol. 10, 195-198 (2015).
12. Ross, C. A. Patterned magnetic recording media. Ann. Rev. Mater. Res. 31, 203-235 (2001).
13. Kim, S. et al. Nanoscale patterning of complex magnetic nanostructures by reduction with low-energy protons. Nature Nanotechnol. 7, 567-571 (2012).
14. Jeong, J., Aetukuri, N., Graf, T., Schladt, T. D., Samant, M. G. & Parkin, S. S. Suppression of metal-insulator transition in VO2 by electric field-induced oxygen vacancy formation. Science 339, 1402-1405 (2013).
15. Lu, N. et al. Electric-field control of tri-state phase transformation with a selective dual-ion switch. Nature 546, 124-128 (2017).
16. Altendorf, S. G., Jeong, J., Passarello, D., Aetukuri, N. B., Samant, M. G. & Parkin, S. S. P. Facet-independent electric-field-induced volume metallization of tungsten trioxide films. Adv. Mater. 28, 5284-5292 (2016).
17. Cui, B. et al. Direct imaging of structural changes induced by ionic liquid gating leading to engineered three-dimensional meso-structures. Nature Commun. 9, 3055 (2018).
18. US 2008/243972 A1
19. US 2008/137406 A1

## Claims

1. The use of a mesosurface manufactured by a method comprising the steps of:
I. providing a substrate which exhibits at least two distinct measurable states of an electron spin property and which can stably but reversibly be transitioned from
i. a first state of the electron spin property into at least
ii. one second state of the electron spin property which is measurably distinct from the first state,
II. creating on a surface of the substrate at least one area
i. outside of which the substrate is in the first state of the electron spin property, and
ii. inside of which the substrate is in one of the at least one second state of the electron spin property,
or
iii. wherein the states of the electron spin property of the inside area and the outside area are inverted, and
III. wherein in step II.ii a desired to be inside area is defined and delineated on the surface of the substrate which is in the first state of the electron spin property and wherein subsequently the surface in the defined and delineated inside area is contacted with a liquid which reacts with the substrate material to yield in or to bring about the transition into the at least one second state of the electron spin property within the inside area only,
or
wherein in step II.iii the states of the electron spin property of the surface and the inside area are inverted, wherein
IV. the individual area of the at least one area has a size of <3 µm² and/or wherein multiple areas form one array or more arrays of areas of regular or irregular shapes of any size, in a magnetic racetrack.

2. The use of claim 1, wherein the electron spin property is a magnetic property.

3. The use of claim 2, wherein the magnetic property is selected from ferromagnetic, ferrimagnetic, anti-ferromagnetic, paramagnetic and diamagnetic property.

4. The use of claim 1, 2 or 3, wherein the substrate material is a material which undergoes a change in the type of magnetic property selected from a first state of one of ferromagnetic, ferrimagnetic, anti-ferromagnetic, paramagnetic and diamagnetic property to a second state which is different from the first state and which is also selected from one of ferromagnetic, ferrimagnetic, anti-ferromagnetic, paramagnetic and diamagnetic property.

5. The use of one of claims 2 to 4, wherein the substrate material is a material, which undergoes a change in degree of the magnetic property.

6. The use of one of claims 1 to 5, wherein the substrate has a thickness in the range of 1-1000 nm, preferably 5-500 nm, more preferably 5-100 nm.

7. The use of one of claims 1 to 6, wherein the liquid brings about a change in the chemical composition of the substrate material.

8. The use of one of claims 1 to 7, wherein the transition is instigated by applying an electric potential to the liquid.

9. The use of claim 8, wherein the electric potential is 0.1-10 Volts, preferably 1-5 Volts, more preferred 2-4 Volts.

10. The use of one of claims 1 to 9, wherein the liquid is selected from one or more of water, an alcohol like ethanol, methanol, a hydrocarbon like pentane, hexane and a halogen containing hydrocarbon like chloroform.

11. The use of one of claims 1 to 9, wherein the liquid is an ionic liquid.

12. The use of claim 11, wherein the ionic liquid is selected from one or more of 1-Ethyl- 3-methylimidazolium bis(trifluoromethylsulfonyl)imide, 1-Propyl-3-methyl-imidazolium bis(trifluoromethylsulfonyl)imide, 1-Butyl-3-methyl-imidazolium bis(tri-fluoromethylsulfonyl)imide and 1-Hexyl-3-methylimidazolium bis(trifluoromethyl-sulfonyl)imide.

## Patentansprüche

1. Verwendung einer mesostrukturierten Fläche, die mittels eines Verfahrens hergestellt wird, welches folgende Schritte umfasst:
I. Bereitstellen eines Substrats, das mindestens zwei unterschiedliche messbare Zustände einer Elektronenspineigenschaft aufweist, wobei es auf stabile, aber reversible Weise einen Übergang von
i. einem ersten Zustand der Elektronenspineigenschaft in mindestens
ii. einen zweiten Zustand der Elektronenspineigenschaft erfahren kann, der sich messbar vom ersten Zustand unterscheidet,
II. Schaffen, auf einer Fläche des Substrats, von mindestens einem Bereich
i. außerhalb dessen sich das Substrat im ersten Zustand der Elektronenspineigenschaft befindet, und
ii. innerhalb dessen sich das Substrat in einem von mindestens einem zweiten Zustand der Elektronenspineigenschaft befindet,
oder
iii. wobei die Zustände der Elektronenspineigenschaft des innenliegenden und des außenliegenden Bereichs umgekehrt vorliegen, und
III. wobei in Schritt II.ii ein Bereich auf der Fläche des Substrats definiert und abgegrenzt wird, von dem angestrebt wird, dass er innenliegend ist, wobei er sich im ersten Zustand der Elektronenspineigenschaft befindet, und wobei anschließend die Fläche des definierten und abgegrenzten innenliegenden Bereichs mit einer Flüssigkeit in Kontakt gebracht wird, die mit dem Substratmaterial reagiert, um ausschließlich in dem innenliegenden Bereich den Übergang in den mindestens einen zweiten Zustand der Elektronenspineigenschaft zu erzielen oder herbeizuführen,
oder
wobei im Schritt II.iii die Zustände der Elektronenspineigenschaft der Fläche und des innenliegenden Bereichs umgekehrt vorliegen, wobei
IV. der einzelne Bereich des mindestens eines Bereichs hat eine Größe von <3 µm² hat und/oder
wobei
mehrere Bereiche ein Array oder mehrere Arrays von Bereichen mit regelmäßiger oder unregelmäßiger Form beliebiger Größe bilden, in einem magnetischen Racetrack.

2. Verwendung nach Anspruch 1, wobei die Elektronenspineigenschaft eine magnetische Eigenschaft ist.

3. Verwendung nach Anspruch 2, wobei die magnetische Eigenschaft aus ferromagnetischen, ferrimagnetischen, antiferromagnetischen, paramagnetischen und diamagnetischen Eigenschaften ausgewählt ist.

4. Verwendung nach Anspruch 1, 2 oder 3, **dadurch gekennzeichnet, dass** es sich bei dem Substratmaterial um ein Material handelt, das eine Änderung der Art der magnetischen Eigenschaft erfährt, die von einem ersten Zustand, welcher einer aus ferromagnetisch, ferrimagnetisch, antiferromagnetisch, paramagnetisch und diamagnetisch ausgewählten Eigenschaft entspricht, in einem zweiten Zustand erfolgt, welcher sich vom ersten Zustand unterscheidet und welcher ebenfalls einer aus ferromagnetisch, ferrimagnetisch, antiferromagnetisch, paramagnetisch und diamagnetisch ausgewählten Eigenschaft entspricht.

5. Verwendung nach einem der Ansprüche 2 bis 4, wobei es sich bei dem Substratmaterial um ein Material handelt, das eine Änderung des Grades der magnetischen Eigenschaft erfährt.

6. Verwendung nach einem der Ansprüche 1 bis 5, wobei das Substrat eine Dicke im Bereich von 1 bis1000 nm, vorzugsweise 5 bis 500 nm, insbesondere 5 bis 100 nm aufweist.

7. Verwendung nach einem der Ansprüche 1 bis 6, wobei die Flüssigkeit eine Änderung der chemischen Zusammensetzung des Substratmaterials hervorruft.

8. Verwendung nach einem der Ansprüche 1 bis 7, **dadurch gekennzeichnet, dass** der Übergang durch Anlegen eines elektrischen Potentials an die Flüssigkeit ausgelöst wird.

9. Verwendung nach Anspruch 8, wobei das elektrische Potential 0,1 bis 10 Volt, vorzugsweise 1 bis 5 Volt, stärker bevorzugt 2 bis 4 Volt beträgt.

10. Verwendung nach einem der Ansprüche 1 bis 9, wobei die Flüssigkeit aus einem oder mehreren von Wasser, einem Alkohol wie Ethanol, Methanol, einem Kohlenwasserstoff wie Pentan, Hexan und einem halogenhaltigen Kohlenwasserstoff wie Chloroform ausgewählt ist.

11. Verwendung nach einem der Ansprüche 1 bis 9, wobei es sich bei der Flüssigkeit um eine ionische Flüssigkeit handelt.

12. Verwendung nach Anspruch 11, **dadurch gekennzeichnet, dass** die ionische Flüssigkeit aus einem oder mehreren von 1-Ethyl-3-methylimidazolium-bis-(trifluormethylsulfonyl)imid, 1-Propyl-3-methylimidazolium-bis-(trifluormethylsulfonyl)imid, 1-Butyl-3-methylimidazolium-bis-(trifluormethyIsulfonyl)imid und 1-Hexyl-3-methylimidazolium-bis-(trifluormethyIsulfonyl)imid ausgewählt ist.

## Revendications

1. Utilisation d'une mésosurface fabriquée par un procédé comprenant les étapes consistant à :
I. fournir un substrat qui présente au moins deux états mesurables distincts d'une propriété de spin d'électrons et qui peut passer de manière stable mais réversible de l'un à l'autre.
i. un premier état de la propriété de spin d'électrons en au moins
ii. un deuxième état de la propriété de spin d'électrons qui est mesurablement distinct du premier état,
II. créer sur une surface du substrat au moins une zone
i. en dehors de laquelle le substrat est dans le premier état de la propriété de spin d'électrons, et
ii. à l'intérieur de laquelle le substrat se trouve dans un état dudit au moins un deuxième état de la propriété de spin d'électrons,
ou
iii. dans lequel les états de la propriété de spin d'électrons de la zone intérieure et de la zone extérieure sont inversés, et
III. dans laquelle, à l'étape II.ii
une zone souhaitée à l'intérieur définie et délimitée sur la surface du substrat qui se trouve dans le premier état de la propriété de spin d'électrons et dans laquelle, par la suite, la surface dans la zone intérieure définie et délimitée est mise en contact avec un liquide qui réagit avec le matériau de substrat pour produire ou provoquer la transition vers ledit au moins un deuxième état de la propriété de spin d'électrons dans la zone intérieure uniquement,
ou
dans laquelle, à l'étape II.iii.
les états de la propriété de spin d'électrons de la surface
et la zone intérieure sont inversées, dans laquelle
IV. la zone individuelle de ladite au moins une zone a une taille de <3 µm² et/ou
dans laquelle
des zones multiples forment un tableau ou plusieurs tableaux de zones de formes régulières ou irrégulières de n'importe quelle taille,
dans une piste de course magnétique.

2. Utilisation de la revendication 1, dans laquelle la propriété de spin d'électrons est une propriété magnétique.

3. Utilisation de la revendication 2, dans laquelle la propriété magnétique est choisie parmi les propriétés ferromagnétiques, ferrimagnétiques, antiferromagnétiques, paramagnétiques et diamagnétiques.

4. Utilisation de la revendication 1, 2 ou 3, dans laquelle le matériau de substrat est un matériau qui subit un changement dans le type de propriété magnétique sélectionné à partir d'un premier état parmi les propriétés ferromagnétiques, ferrimagnétiques, antiferromagnétiques, paramagnétiques et diamagnétiques jusqu'à un deuxième état qui est différent du premier état et qui est également sélectionné parmi une des propriétés suivantes : la propriété ferromagnétique, la propriété ferrimagnétique, la propriété antiferromagnétique, la propriété paramagnétique et la propriété diamagnétique.

5. Utilisation de l'une des revendications 2 à 4, dans laquelle le matériau de substrat est un matériau, qui subit un changement de degré de la propriété magnétique.

6. Utilisation de l'une des revendications 1 à 5, dans laquelle le substrat a une épaisseur comprise entre 1 et 1000 nm, de préférence entre 5 et 500 nm, plus préférentiellement entre 5 et 100 nm.

7. Utilisation de l'une des revendications 1 à 6, dans laquelle le liquide entraîne une modification de la composition chimique du matériau de substrat.

8. Utilisation de l'une des revendications 1 à 7, dans laquelle la transition est déclenchée par l'application d'un potentiel électrique au liquide,

9. Utilisation de la revendication 8, dans laquelle le potentiel électrique est de 0,1 à 10 volts, de préférence de 1 à 5 volts, plus préférentiellement de 2 à 4 volts.

10. Utilisation de l'une des revendications 1 à 9, dans laquelle le liquide est choisi parmi un ou plusieurs des éléments suivants : l'eau, un alcool comme l'éthanol, le méthanol, un hydrocarbure comme le pentane, l'hexane et un hydrocarbure halogéné comme le chloroforme.

11. Utilisation de l'une des revendications 1 à 9, dans laquelle le liquide est un liquide ionique.

12. Utilisation de la revendication 11, dans laquelle le liquide ionique est choisi parmi un ou plusieurs des éléments suivants :
le 1-éthyl-3-méthylimidazolium bis(trifluorométhylsulfonyl)imide, le 1-propyl-3-méthyl-imidazolium bis(trifluorométhylsulfonyl)imide, le 1-butyl-3-méthyl-imidazolium bis(trifluorométhylsulfonyl)imide et le 1-hexyl-3-méthylimidazolium bis(trifluorométhylsulfonyl)imide.
